# EUROPÄISCHE PATENTSCHRIFT

(11) **EP 2 936 945 B1**
(45) Veröffentlichungstag und Bekanntmachung des Hinweises auf die Patenterteilung: **01.07.2020**
(21) Anmeldenummer: 13810956.6
(22) Anmeldetag: 19.12.2013
(51) Int. Cl.: H05K 1/02, H05K 1/14, H05K 1/03, H05K 3/38, H05K 3/36, H01L 23/367, H01L 23/498

(54) **BAUELEMENT, VERFAHREN ZUR HERSTELLUNG EINES BAUELEMENTS, BAUELEMENTANORDNUNG, SOWIE VERFAHREN ZUM APPLIZIEREN EINES BAUELEMENTS**
COMPONENT, METHOD FOR MANUFACTURING A COMPONENT, COMPONENT ASSEMBLY, AND METHOD FOR APPLYING A COMPONENT
COMPOSANT, PROCÉDÉ DE FABRICATION D'UN COMPOSANT, AGENCEMENT DE COMPOSANT ET PROCÉDÉ D'APPLICATION D'UN COMPOSANT

(30) Priorität: 19.12.2012 EP 12198031
(43) Veröffentlichungstag der Anmeldung: 28.10.2015
(73) Patentinhaber: Forster Rohner AG, 9006 St. Gallen (CH)
(72) Erfinder: ZIMMERMANN, Jan-Helge, CH-8057 Zürich (CH)
(74) Vertreter: Hepp Wenger Ryffel AG
(86) Internationale Anmeldenummer: PCT/EP2013/077301
(87) Internationale Veröffentlichungsnummer: WO 2014/096140

(56) Entgegenhaltungen:
- EP-A1- 2 355 645
- EP-A1- 2 562 692
- WO-A1-2009/003299
- DE-A1-102011 005 606
- US-A- 3 926 360
- US-A1- 2004 164 396
- US-A1- 2004 224 138
- US-A1- 2005 279 529
- US-B1- 6 229 124
- US-B1- 6 437 251

## Beschreibung

Die Erfindung betrifft ein Bauelement zum Anbringen auf ein flexibles Substrat, ein Verfahren zur Herstellung eines solchen Bauelements, eine Bauelementanordnung umfassend ein flexibles Substrat mit Leiterbahnen und mindestens ein Bauelement, sowie ein Verfahren zum Applizieren eines Bauelements auf ein flexibles Substrat.

Im Folgenden werden Bauelemente betrachtet, welche Bauteile umfassen, die mit Strom und/oder Spannung beaufschlagbar sind und/oder die elektrische Signale abgeben, insbesondere elektronische Bauteile.

Die Verbindung von derartigen Bauelementen mit flexiblen Substraten, insbesondere die Verbindung von funktionellen elektronischen Bauelementen mit Textilien zur Herstellung von sogenannten Intelligenten Textilien oder "Smart Fabrics" stellt nach wie vor eine bisher für den praktischen Gebrauch ungelöste grosse Herausforderung dar.

Die Bauelemente müssen in ihrer Form, in der Dimensionierung und in den zulässigen Toleranzen auf die besonderen Gegebenheiten eines flexiblen, insbesondere textilen Substrates, welches nicht den in z.B. der Elektronikindustrie gängigen Standards entspricht, ausgelegt werden.

Die entstehende Bauelementanordnung muss sowohl die für eine sichere Funktion notwendigen elektrischen Anforderungen, als auch die für den typischen, textilen Gebrauchseinsatz notwendigen textilen Anforderungen erfüllen. So müssen einerseits eine verlässliche leitfähige elektrische Kontaktierung und andererseits eine robuste mechanische Anbindung gegeben sein.

Nach einer Verbindung von elektronischen Komponenten mit einem Textil muss das Produkt wiederholten Waschvorgängen in einer Haushaltswaschmaschine standhalten, ohne seine Funktion zu verlieren.

Die eingesetzten Verfahren und Komponenten müssen für eine Vielzahl von textilen Materialien, Formen und Geometrien einsetzbar sein, d.h. für Leder oder lederartige Materialien, für Folien oder folienartigen Materialien, für Gewebe, Gewirke und Gestricke, für Vliesstoffen, wobei die Materialien aus einer Auswahl aus einer Vielzahl von Materialitäten gefertigt sein können. Die Verfahren und Komponenten sollen dazu geeignet sein, dass die Bauteile auf Substraten mit Grössen von einigen Quadratzentimetern bis hin zu mehreren Quadratmetern Fläche aufgebracht werden können, die auf in der Textilindustrie typischerweise verwendeten Maschinen verarbeitbar sind.

Schlussendlich müssen die eingesetzten Verfahren zur Herstellung eines robusten Textils möglichst effizient und damit kostengünstig sein, was insbesondere bedeutet, dass keine komplexen Verfahrensschritte oder neuartige, kostspielige Infrastrukturen benötigt werden.

Aus dem Stand der Technik sind Bauelemente und Verfahren zum Verbinden von Bauelementen mit flexiblen Substraten bekannt.

So zeigt beispielsweise die Druckschrift GB2396252 ein mit Leiterbahnen versehenes Textil, auf welchem lichtemittierende Dioden (LEDs) angeordnet sind. Die LEDs sind mit leitfähigem Klebstoff fixiert und die so befestigten LEDs werden anschliessend mit einer Schutzschicht überzogen.

Das nachträgliche Verkapseln der LEDs stellt einen zusätzlichen Verfahrensschritt dar, der das Verfahren aufwändig macht. Zudem beeinträchtigt die nachträglich aufgebrachte Schutzschicht den textilen Charakter. Die Flexibilität, die Drapierfähigkeit, die haptischen Eigenschaften des Substrats und die optische Wirkung der Oberfläche gehen weitgehend verloren.

In der Druckschrift WO03052875 wird ein Verfahren zur elektrischen Verbindung einer elektrischen Leiterbahn auf einem textilen Material mit einem Bauelement beschrieben. Hier wird das elektrische Bauelement entweder direkt oder indirekt über einen sogenannten Hilfskontakt durch Aufbringung von Lot und Löten oder Aufbringung von leitfähigem Kleber und Kleben unter Ausübung von Druck elektrisch mit der Leiterbahn verbunden. Die Herstellung einer Löt- oder Klebeverbindung mit einem Hilfskontakt ist, insbesondere wenn sie kleinflächig ausgebildet ist, aufwendig und bildet insbesondere für textile Anwendungen keine ausreichend strapazierfähige mechanische Verbindung.

Das textile Substrat ist insbesondere derart gewählt, dass es beim Lötprozess teilweise aufschmilzt und eine mechanische Klebeverbindung zum Bauteil oder Hilfsbauteil entsteht. In der Praxis erweist sich diese mechanische Zusatzverbindung als unzureichend und schwer zu realisieren.

Die Druckschrift WO2005067042 schlägt vor, ein mechanisches Verbinden eines textilen Materials mit einem Bauelement durch Verkleben bzw. eine Klebeverbindung zu erreichen und gleichzeitig eine elektrisches Verbindung herzustellen, indem ein Leiter auf einem textilen Substrat mit einer leitfähigen Kontaktstelle des Bauteils mittelbar und/oder unmittelbar miteinander in Kontakt gebracht werden.

Hierzu wird ein isolierender Klebstoff verwendet, der unter Druck beim Aufbringen des Bauteils zwischen Leiterbahn und Bauteilkontaktstelle verdrängt wird und so den Kontakt erlaubt. Alternativ wird ein mit leitfähigen Partikeln versetzter Klebstoff verwendet.

In der Praxis erweist sich dieses Verfahren als eingeschränkt geeignet, da mit ihm ein zuverlässiger und im Gebrauch dauerhafter elektrischer Kontakt insbesondere bei kleinflächigen Kontaktstellen schwer zu realisieren ist. Ebenso kann ein mit leitfähigen Partikeln versetzter Klebstoff nicht grossflächig auf ein Bauteil aufgebracht werden, da so unerwünschte Kontaktstellen entstehen können. Eine selektive Aufbringung von mit leitfähigen Partikeln versetztem Klebstoff nur auf die Kontaktstellen und ein zusätzliches Aufbringen von Klebstoff ohne leitfähige Partikel auf den Rest des Bauteils ist in der Praxis schwer zu realisieren.

Die Druckschrift US 2004/0224138 A1 offenbart elektrisch aktive Textilien, die durch punktuelle Befestigung eines Bauelements auf einer textilen Unterlage hergestellt werden. Die Befestigung der Bauteile kann beispielsweise mittels Klebstoff erfolgen. Die elektrische Verbindung von Lötpads des Bauelements mit Leiterbahnen der textilen Unterlage ist ebenfalls in einer Ausführungsform offenbart.

Um die Befestigungspunkte zu entlasten und eine mechanisch beanspruchbare Verbindung zu erhalten, muss die Flexibilität dieser Konstruktion durch Entlastungszonen, wie sie beispielsweise Löcher oder Ausnehmungen darstellen, erhöht werden. Dies wirkt sich allerdings auch nachteilig auf die Strapazierfähigkeit der Bauteile selbst aus.

Gemäss EP2030493 werden elektronische Bauteile auf einem Subträger angeordnet, der in ein Substrat eingreifende Elemente aufweist, die von dem Subträger abstehen und auf der Rückseite des Substrats umgebogen werden können.

Der Subträger kann also durch einen mechanischen Crimpkontakt elektrisch und mechanisch mit Leiterbahnen auf einem Substrat verbunden werden. Der mechanische Crimpkontakt ist nicht für alle Anwendungen geeignet, beispielsweise, wenn das Substrat nicht durchstochen werden soll, und hinsichtlich seiner elektrischen Eigenschaften nicht in allen Fällen ausreichend gut. Er muss dann gegebenenfalls durch leitfähigen Kleber verbessert werden.

Die Herstellung der Verbindung ist somit aufwendig.

Aus der EP 2 562 692 A1 ist ein Chipmodul mit Leiteranordnungen auf einer Ober- und einer Unterseite einer Leiterplatte bekannt, welche auf einem flexiblen Substrat befestigt werden kann. Die Leiterplatte weist Löcher auf, an deren Wänden sich leitfähiges Material zum elektrischen Verbinden der Leiteranordnungen auf der Ober- und Unterseite der Leiterplatte befindet. Durch das Einbringen von Lotdepots in die Öffnungen kann das leitfähige Material an den Innenwänden der Löcher mit speziellen Kontaktstellen auf dem flexiblen Substrat elektrisch und mechanisch verbunden werden.

Nachteilig an der beschriebenen Konstruktion ist, dass die elektrische und mechanische Verbindung von Chipmodul und flexiblem Substrat lediglich punktuell über Lötverbindungen erfolgt, was sich negativ auf die mechanische und elektrische Robustheit und Verlässlichkeit der Verbindung zum Substrat auswirkt.

DE102007001411 beschreibt ein weiteres Verfahren, um ein Elektronikbauteilmodul mit einem auf ein Textil aufgebrachten leitfähigen Draht zu verbinden. Hier wird ein mit Lotkugeln versetzter Klebstoff mindestens im Bereich der Anschlussstellen auf das Elektronikbauteilmodul und/oder auf die textilen Anschlussstellen aufgebracht. Durch Hitze und Druck wird das Bauteilmodul auf die Verbindungsstelle aufgebracht, wobei bei genügend hoher Temperatur die Lotkugeln aufschmelzen und eine Lötverbindung zum Draht herstellen. Der Klebstoff soll im gleichen Schritt eine robuste Klebeverbindung herstellen oder nachträglich ausgehärtet werden.

Die selektive Aufbringung von Heisskleber und Lotkugeln stellt einen aufwendigen Prozessschritt dar, insbesondere wenn erst der Heissklebefilm und anschliessend die Lotkugeln aufgebracht werden.

In dem beschriebenen Verfahren läuft man mit der Erhitzung des Lots Gefahr, den Klebefilm zu zersetzen, sowie die Elektronikbauteile und/oder das textile Substrat thermisch zu beeinträchtigen. Eine schonende Erwärmung der Anschlussstelle bis zum Schmelzpunkt des Lotes bzw. nicht über die Zersetzungstemperatur des Klebers bedeutet relativ lange Prozesszeiten und möglicherweise unzureichende Lötverbindungen.

Für die Herstellung miniaturisierter, dreidimensionaler elektronischer Schaltungen ist es zum Beispiel aus US 6,977,441 bekannt, Schaltungen von übereinander liegenden Substraten durch Löcher in den Substraten elektrisch zu kontaktieren und die Substrate mit Klebeverbindungen aneinander zu fixieren. Die aus der Elektronik bekannten Verbindungsmethoden, welche in der Regel Fehlertoleranzen im Bereich von Hundertsteln Millimetern erfordern, sind zu filigran, um für textile Substrate eingesetzt zu werden.

Aus der EP 2 355 645 A1 ist eine Montageeinrichtung zum Ausstatten von Substraten mit RFID-Transponderchips bekannt, mit der ein punktgenaues Aufschmelzen der Stellen, an denen das Lötmittel auf dem RFID-Chipmodul angeordnet ist, ermöglicht wird. Allerdings wirkt sich diese, lediglich punktuelle Lötverbindung zwischen RFID-Chipmodul und Substrat nachteilig auf die mechanische Beanspruchbarkeit und Langlebigkeit des Erzeugnisses aus. Es stellt sich daher die Aufgabe, die Nachteile des Bekannten zu vermeiden und ein Bauelement, ein Verfahren zur Herstellung eines solchen Bauelements, eine Bauelementanordnung sowie ein Verfahren zum Applizieren eines Bauelements zur Verfügung zu stellen, die eine verlässliche leitfähige elektrische Kontaktierung und eine robuste mechanische Anbindung, bevorzugt zu einem flexiblen, elastischen, drapierfähigen und/oder nicht formstabilen Substrat, ermöglichen, die in einem einfachen und kostengünstigen Verfahren hergestellt werden können.

Die Aufgabe wird gelöst durch ein Bauelement entsprechend Anspruch 1 zum Anbringen auf ein flexibles, textiles Substrat, das einen Bauteilträger umfasst und mindestens ein auf dem Bauteilträger montiertes Bauteil. Bei dem Substrat handelt es sich um ein textiles Substrat.

Der Bauteilträger besitzt eine erste Oberfläche, die dem Substrat zuzuwenden ist und eine, bevorzugt der ersten Oberfläche gegenüberliegende, zweite Oberfläche.

Das Bauteil ist mit Strom und oder Spannung beaufschlagbar und/oder es gibt elektrische Signale ab, insbesondere handelt es sich um ein elektronisches Bauteil.

Die erste Oberfläche des Bauteilträgers ist zumindest teilweise mit einem Klebestoff, insbesondere einem Klebefilm, überzogen. Die mechanische Verbindung zum Substrat kann durch den Klebestoff hergestellt werden. Die dem Substrat zuzuwendende Oberfläche des Bauteilträgers ist somit effektiv ausgenutzt mit Bereichen, die für eine elektrische Kontaktierung genutzt werden können und mit Bereichen, die für eine mechanische Verbindung sorgen.

Es sind bevorzugt 50%, weiter bevorzugt mindestens 70%, weiter bevorzugt mindestens 80%, der dem Substrat zuzuwendenden Oberfläche des Bauelements mit Klebstoff überzogen.

Vorteilhafterweise ist der Randbereich, entlang mindestens 50% der Umfangskante, bevorzugt entlang mindestens 80% der Umfangskante, der dem Substrat zuzuwendenden Oberfläche des Bauelements mit Klebstoff überzogen.

Die Dicke des Klebefilms beträgt bevorzugt 0.01 bis 0.5mm, weiter bevorzugt zwischen 0.05 und 2mm.

Das Flächengewicht des Klebstoffes beträgt bevorzugt zwischen 10 g/m² und 500 g/m², besonders bevorzugt zwischen 20 g/m² und 200 g/m², weiter bevorzugt zwischen 50 g/m² und 100 g/m².

Die Menge an Klebstoff ist somit ausreichend, um das Bauelement stabil und dauerhaft auf einem textilen Substrat, also auf einem flexiblen, dehnbaren und/oder zumindest wenig formstabilen Untergrund, zu befestigen.

Die Bauteile können im Standardverfahren der Leiterplattenbestückung auf den Bauteilträger aufgebracht werden und können somit vollständig industriell gefertigt werden. Die Bauteile können auf einer oder auf beiden Seiten des Bauteilträgers aufgebracht sein. Vorteilhafterweise sind die Bauteile auf der dem Substrat zuzuwendenden Fläche des Bauteilträgers aufgebracht, da sie so nach dem Aufbringen auf das Substrat geschützt sind. Insbesondere können die Bauteile als sogenannte "reverse-mount" Bauteile auf der dem Substrat zuzuwendenden Fläche aufgebracht werden, aber durch ein Loch in dem Bauteilträger auf der gegenüberliegenden Seite sichtbar sein. Hierdurch sind die Anschlussstellen geschützt, die Bauteile wirken aber auf der von dem Substrat abgewandten Seite, was beispielsweise wichtig für LEDs oder Sensoren ist.

Erfindungsgemäss weist der Bauteilträger mindestens zwei Lotdepots auf, welche auf der ersten Oberfläche des Bauteilträgers angeordnet sind.

Die Lotdepots befinden sich bevorzugt an Kontaktstellen, über welche das Bauteil mit Strom und/oder Spannung versorgbar ist.

Die Lotdepots erlauben eine elektrische Kontaktierung mit einer auf dem Substrat befindlichen Leiterbahn.

Die Menge des aufgebrachten Lotes hängt von der Grösse der Kontaktstelle ab und von den Gegebenheiten der Leiterbahnen auf dem insbesondere textilen Substrat.

Die Lotdepots haben typischerweise eine dem Substrat zuwendenden Fläche, deren Grösse in einem Bereich zwischen 0.2 mm² bis 100 mm², bevorzugt zwischen 0.5 mm² und 50 mm², weiter bevorzugt zwischen 1 mm² und 10 mm², liegt.

Die Schichtdicke der Lotdepots beträgt bevorzugt 0.01-1mm, bevorzugt 0.05-0.5mm.

Damit liegt genügend Lotmaterial vor, um eine stabile und dauerhafte elektrische Verbindung mit einer Leiterbahn herzustellen, die auf einem textilen Substrat angeordnet ist, also auf einem flexiblen, dehnbaren, drapierbaren und/oder zumindest wenig formstabilen Untergrund.

Bevorzugt haben die Lotdepots vom Rand des Bauteilträgers einen Abstand von mindestens 0.1mm, bevorzugt von mindestens 0.2mm, so dass das Lot bei einem Aufschmelzen nicht unter dem Bauelement hervorquillt.

Der Abstand vom Rand sorgt vor allem dafür, dass zwischen dem Lotdepot und dem Rand des Bauteilträgers noch Klebstoff Platz findet, so dass die Kontaktstelle nach dem Aufbringen von allen Seiten mechanisch stabilisiert ist.

Bevorzugt haben die Lotdepots voneinander einen Abstand von mindestens 0.3mm, bevorzugt von mindestens 0.5mm, weiter bevorzugt von mindestens 1mm, damit es bei einem Aufschmelzen nicht zu einer gegenseitigen Kontaktierung kommt.

Erfindungsgemäss weist der Bauteilträger mindestens zwei thermisch leitfähige Kanäle auf, welche von der ersten zur zweiten Oberfläche führen, die jeweils thermisch leitend mit mindestens einem Lotdepot verbunden sind, welches auf der ersten Oberfläche des Bauteilträger angeordnet ist.

Über die thermisch leitfähigen Kanäle kann das Lot erwärmt werden, indem Wärme an das Kanalende geführt wird, welches an der zweiten Oberfläche liegt. Für ein Erwärmen des Lotdepots muss also die Wärme nicht direkt an die erste Oberfläche des Bauteilträgers herangeführt werden. Insbesondere ist es nicht unbedingt notwendig, die komplette erste Oberfläche des Bauteilträgers oder sogar den gesamten Bauteilträger einschliesslich der Bauteile zu erhitzen.

Die thermisch leitfähigen Kanäle können in Form von Bohrungen in dem Bauteilträger vorliegen. Diese können an der Innenseite mit einer thermisch leitfähigen Schicht, beispielsweise einer Metallschicht, versehen sein. Die Kanäle können in Form von komplett mit thermisch leitfähigem Material, bevorzugt Metall, gefüllten Bohrungen vorliegen.

Insbesondere liegen die Kanäle als Ausnehmungen, bevorzugt als Bohrungen, in dem Bauteilträger vor, die zumindest teilweise mit Lot gefüllt sind, wobei das Lot jeweils elektrisch leitend mit mindestens einem Lotdepot verbindbar ist. Insbesondere kann die Lotfüllung der Kanäle in direktem Kontakt mit den Lotdepots auf der ersten Seite des Bauteilträgers stehen.

Bei einer Erwärmung der Kanäle an der zweiten Oberfläche des Bauteilträgers verflüssigt sich das Lotmaterial in den Kanälen und sorgt dafür, dass die Lotdepots auf der anderen Seite des Bauteilträgers erwärmt werden und eine Lötverbindung mit den Leiterbahnen auf dem Substrat bilden können.

Vorteilhafterweise ist die dem Substrat zuzuwendende Seite des Bauelements mit Klebstoff überzogen. Insbesondere sind auch die Lotdepots mit Klebefilm überzogen. Bei der Erwärmung der Lotdepots wird der Klebefilm von den Lotdepots verdrängt, entweder zersetzt oder verflüssigt und weg geschoben, so dass er die elektrische Kontaktierung zu den Leitungsbahnen auf dem Substrat nicht beeinträchtigt. Gleichzeitig steht die gesamte Fläche des Bauteilträgers ausserhalb der Lotdepots zur Herstellung der mechanischen Verbindung zur Verfügung.

Mit dem erfindungsgemässen Bauelement lässt sich daher eine robuste mechanische und eine verlässliche elektrisch leitfähige Verbindung zu dem Substrat herstellen.

Bei dem Klebstoff kann es sich um einen Klebstoff handeln, der durch Polymerisation seine Klebewirkung entfaltet. Bevorzugt ist der Klebstoff jedoch thermisch aktivierbar und/oder thermisch aushärtbar. Insbesondere handelt es sich um einen thermoplastischen Schmelzklebstoff, zum Beispiel Polyamid, der bevorzugt eine Schmelztemperatur zwischen 50°C und 200°C aufweist, besonders bevorzugt zwischen 90°C und 160°C.

Der Klebstoff ist bevorzugt als Klebefilm auf dem Bauteil angebracht. Dieser kann als Folie grossflächig auf das Bauteil aufgebracht werden, etwa durch Aufschmelzen in einem Ofen, durch Laminieren, durch Sprayen oder Ähnliches.

Als Klebstoff wird bevorzugt eine Klebefolie mit einem Flächengewicht zwischen 10 g/m² und 500 g/m² verwendet, bevorzugt zischen 20 g/m² und 200 g/m², weiter bevorzugt zwischen 50 g/m² und 100 g/m².

In einer vorteilhaften Ausführung der Erfindung ist der Bauteilträger plattenförmig ausgebildet. Er besteht insbesondere aus einem elektrisch und/oder thermisch isolierenden Material, beispielsweise aus glasfasergefülltem FR4 Epoxyd oder Kapton.

Der Bauteilträger soll bevorzugt keine spitzen Kanten aufweisen, sondern abgerundete Kanten, mit einem Radius von bevorzugt mindestens 0.5mm, besonders bevorzugt von mindestens 1mm, weiter bevorzugt von mindestens 2mm.

Der Bauteilträger soll ebenfalls keine spitzen Ecken aufweisen, sondern, falls er nicht ohnehin eine runde oder ovale Kontur besitzt, im Bereich zweier zusammenlaufender Kanten eine abgerundete Kontur aufweisen, bevorzugt mit einem Radius von mindestens 0.5mm, besonders bevorzugt von mindestens 1mm, weiter bevorzugt von mindestens 2mm.

Der plattenförmige Bauteilträger hat bevorzugt eine Materialstärke zwischen 10 µm und 2000 µm, besonders bevorzugt zwischen 100 und 1000 µm.

Für die bevorzugte Anwendung auf flexiblen, insbesondere textilen Substraten ist es von Vorteil, wenn der Bauteilträger eine Form annimmt, die die Flexibilität oder den Griff des Substrates möglichst wenig beeinflusst. Hierzu sollten die Bauteilträger bevorzugt eine Grösse von 2mm² - 10000mm², weiter bevorzugt von 10 mm² - 5000 mm², besonders bevorzugt 25 mm² - 2500mm², aufweisen.

Der Bauteilträger ist dafür geeignet, verschaltete Bauteile zu tragen. Der Bauteilträger kann mehrlagig ausgeführt sein und ähnlich wie eine mehrlagige Leiterplatte ausgebildet sein, um komplexe Funktionen zu realisieren. Bereiche des Bauteilträgers können im Herstellungsprozess mit geeigneten Lacken einer beliebigen Farbe versehen werden, die verschiedene Bereiche voneinander elektrisch isolieren oder Lotmaterial am Weiterfliessen hindern. Die Verwendung von thermisch isolierendem Material sorgt dafür, dass bei der Erwärmung der Kanäle vorwiegend das Lotdepot erwärmt wird und nicht die Bauteile oder Schaltungen auf dem Bauteilträger.

In einer vorteilhaften Ausführung der Erfindung handelt es sich bei dem Bauteil um mindestens ein verschaltetes mikroelektronisches Bauteil, zum Beispiel aus der Gruppe von Diode, Widerstand, Kondensator, Spule, Mikrokontroller und/oder Sensor. Es kann sich aber auch um ein Bauteil handeln, das Energie speichern und/oder abgeben kann, zum Beispiel eine Solarzelle oder eine Batterie.

Die Bauteile sind auf dem Bauteilträger derartig angeordnet und verschaltet, dass sie über Kontaktstellen, an denen sich die Lotdepots befinden, elektrisch versorgt werden können und/oder eine elektrische Versorgung zur Verfügung stellen können.

Das mindestens eine Bauteil kann also mit den Leiterbahnen auf dem Substrat derart in eine Verbindung gebracht werden, dass es montiert auf dem Substrat eine Funktion erfüllen kann.

In einer vorteilhaften Ausführung des Bauelements besitzt dieses Kanäle, die jeweils einen Durchmesser aufweisen, der in einem Bereich von 0.1mm bis 2mm liegt, bevorzugt von 0.2mm bis 1mm liegt. Die Kanäle können so mit einer ausreichenden Menge von Lotmaterial gefüllt sein und die Kanäle stellen einen verlässlichen Wärmekontakt zum Lotdepot her.

Insbesondere haben die Kanäle bevorzugt jeweils einen Abstand von mindestens 0.1mm, besonders bevorzugt von 0.5mm vom Rand des Bauteilträgers.

Der Abstand vom Rand sorgt dafür, dass aus den Kanälen kein Lotmaterial in die Umgebung des Bauteilträgers gerät oder aus den Kanälen auf das Substrat läuft. Der Abstand vom Rand sorgt zudem für eine elektrische und/oder thermische Isolierung der Kanäle, sodass Lotmaterial nicht nennenswert erwärmt wird, wenn nicht einem Kanalende Wärme zugeführt wird.

Der Abstand vom Rand sorgt vor allem dafür, dass zwischen dem Lotdepot und dem Rand des Bauteilträgers noch Klebstoff Platz findet, so dass die Kontaktstelle nach dem Aufbringen von allen Seiten mechanisch stabilisiert ist.

Bevorzugt haben die Kanäle einen Abstand voneinander, der mindestens 0.5 mm beträgt, bevorzugt mindestens 1mm, weiter bevorzugt mindestens 2mm.

Das Lotmaterial in den Kanälen steht spätestens nach der Anbringung des Bauelements auf dem Substrat mit den Lotdepots in Verbindung, die ihrerseits mit den Leiterbahnen und den Bauteilen in Verbindung stehen. Die Kanäle müssen daher ausreichend isoliert sein, damit es nicht zu einer unbeabsichtigten Verschaltung, Strom- und/oder Spannungsversorgung kommt.

Als Lotfüllung in den Kanälen wird bevorzugt dasselbe Lotmaterial verwendet wie für die Lotdepots.

Es kann ein Weichlotmaterial verwendet werden, wie beispielsweise Lötzinn. Es ist allerdings auch möglich, Silberlot, Bleilot oder Messinglot zu verwenden.

Das Lotmaterial hat bevorzugt eine Schmelztemperatur zwischen 130°C und 230°C, weiter bevorzugt zwischen 150°C und 200°C, insbesondere bevorzugt zwischen 160°C und 180°C.

Es können auch mehrere Kanäle vorgesehen sein, über welche ein bestimmtes Lotdepot thermisch zugänglich ist.

Der Kanal kann, insbesondere auf der zweiten Seite, mit einer, insbesondere leitfähigen, Abdeckung versehen sein. Bei dem Material, mit dem der Kanal gedeckelt ist, kann es sich zum Beispiel um eine Schicht aus Kupfer, insbesondere einem vergoldeten Kupfer, handeln. Hierdurch lässt sich beispielsweise das optische Erscheinungsbild der Kanäle auf dem Bauteilträger kontrolliert bestimmen. Die Abdeckung ist insbesondere ebenfalls thermisch leitfähig, so dass immer noch verlässlich und ausreichend Wärme an die Kanäle herangebracht werden kann.

Alternativ oder zusätzlich kann ein Bereich um das Kanalende herum mit einem thermisch leitfähigen Material beschichtet sein, um den Kontakt beispielsweise mit einer Lötspitze zu verbessern. Der Bereich hat typischerweise eine Breite von 0.1mm bis 1mm, vorzugsweise zwischen 0.2mm und 0.5mm.

In einer vorteilhaften Ausführung der Erfindung weist das erfindungsgemässe Bauelement mindestens eine der folgenden Eigenschaften a)- h) auf:
a) jedes Lotdepot weist eine dem Substrat zuzuwendenden Fläche auf, deren Grösse in einem Bereich zwischen 0.2 mm² bis 100 mm², bevorzugt zwischen 0.5 mm² und 50 mm², weiter bevorzugt zwischen 1 mm² und 10 mm² liegt,
b) die Schichtdicke der Lotdepots beträgt 0.01-1mm, bevorzugt 0.05-0.5mm,
c) jedes Lotdepot hat vom Rand des Bauteilträgers einen Abstand von mindestens 0.1mm, bevorzugt von mindestens 0.2mm,
d) jedes Lotdepot hat von jedem anderen Lotdepot einen Abstand von mindestens 0.3mm, bevorzugt von mindestens 0.5mm, weiter bevorzugt von mindestens 1mm,
e) mindestens 50%, weiter bevorzugt mindestens 70%, weiter bevorzugt mindestens 80%, der ersten Oberfläche sind mit Klebstoff überzogen,
f) die Dicke des Klebestoffs liegt im Bereich 0.01-0.5mm, bevorzugt 0.05-0.2mm,
g) das Flächengewicht des Klebstoffs liegt im Bereich von 10-500 g/m², bevorzugt 20-200 g/m², bevorzugt 50-100 g/m²,
h) der Bauteilträger hat eine Materialstärke im Bereich von 10 µm bis 2000 µm, bevorzugt von 100 µm bis 1000 µm.

Die Aufgabe wird weiterhin gelöst durch ein Verfahren zur Herstellung eines Bauelements wie oben beschrieben, das durch die folgenden Verfahrensschritte gekennzeichnet ist. Zunächst wird ein Bauteilträger mit mindestens einem Bauelement bestückt. Das Bauelement kann auf die dem Substrat zuzuwendende Oberfläche des Bauteilträgers angebracht werden oder auf einer anderen Oberfläche. Das Bauelement kann auch in den Bauteilträger eingelagert sein.

Es werden mindestens zwei thermisch leitfähige Kanäle angebracht, die jeweils von einer ersten Seite des Bauteilträgers zu einer zweiten Seite des Bauteilträgers führen, insbesondere werden von einer ersten Seite des Bauteilträgers zu einer zweiten Seite des Bauteilträgers durchgehende Ausnehmungen bereitgestellt, in welche Lot gefüllt wird.

Auf der ersten Seite des Bauteilträgers werden mindestens zwei Lotdepots angebracht, die insbesondere in einer elektrischen Verbindung mit dem Bauelement stehen.

Ausserdem wird ein Klebstoff auf eine dem Substrat zuzuwendende Seite des Bauelements aufgetragen. Der Klebstoff wird bevorzugt in einem abschliessenden Schritt als Klebefilm auf das Bauelement aufgetragen.

Alternativ kann der Film auch schon vor dem Anbringen der Lotdepots auf die dem Substrat zuzuwendende Seite des Bauteilträgers aufgebracht werden.

Das Anbringen der Lotdepots kann in einem Verfahrensschritt mit dem Füllen von Ausnehmungen zum Bilden von Kanälen erfolgen.

Der Bauteilträger wird je nach Bedürfnissen mit leitfähigen Bereichen, Leiterbahnen, Bohrungen, Durchkontaktierungen, Lötkontaktstellen und/oder dergleichen zum Aufbringen und Verschalten der Bauteile versehen.

Die Kanäle können bei der Herstellung des Bauteilträgers als durchgehende Ausnehmungen angelegt sein, sie können aus dem Bauteilträger gestanzt, gefräst oder mittels Schneidwerkzeug, Ultraschall oder Laser geschnitten werden. Bevorzugt werden die Ausnehmungen gebohrt.

In einer vorteilhaften Ausführung des Verfahrens werden zum Bilden der Kanäle die Wandungen der Ausnehmungen leitfähig beschichtet, insbesondere bevor die Ausnehmungen mit Lot gefüllt werden. Zusätzlich können auf der ersten und/oder zweiten Seite des Bauteilträgers Bereiche, welche die Kanäle umgeben, leitfähig beschichtet werden.

In einer vorteilhaften Ausführung des Verfahrens werden die Kanäle auf der zweiten Seite des Bauteilträgers mit einer Deckelung versehen, insbesondere einer Kupferschicht. Die Deckelung schützt die Lotfüllung in den Kanälen und sorgt gleichzeitig dafür, dass das Lotdepot dennoch von der zweiten Seite des Bauteilträgers thermisch beaufschlagbar ist.

In einer bevorzugten Ausführung des Verfahrens wird eine Vielzahl von Bauelementen, insbesondere parallel, auf einer Bauteilträgerplatte gefertigt und insbesondere die Bauelemente in einem nachfolgenden Schritt durch eine Teilung der Bauteilträgerplatte vereinzelt. Es kann so in für die elektronische Bauteilfertigung üblichen Prozessschritten eine Vielzahl von Bauelementen gleichzeitig gefertigt werden.

Das Vereinzeln der Bauelemente kann als Teil des Herstellprozesses erfolgen oder unmittelbar vor dem Aufbringen des Bauelements auf ein Substrat als Teil des Aufbringprozesses. Die Vereinzelung kann durch Brechen, Schneiden, Fräsen oder Stanzen erfolgen.

Die Aufgabe wird ausserdem gelöst durch eine Bauelementanordnung, die ein flexibles, insbesondere textiles, Substrat umfasst, welches mit Leiterbahnen versehen ist, und mindestens ein Bauelement wie oben beschrieben.

Mindestens zwei Lotdepots des Bauelements sind mit je einer Leiterbahn auf den Substrat elektrisch leitend verbunden. Zwischen dem Bauteilträger und dem Substrat besteht ein Klebekontakt.

Eine so hergestellte Bauelementanordnung besitzt eine robuste elektrische und mechanische Verbindung, die beispielsweise einer Vielzahl von Waschvorgängen in einer handelsüblichen Waschmaschine standhält, ohne ihre Funktionalität einzubüssen.

Bevorzugt sind die Leiterbahnen auf einem textilen Substrat angebracht, insbesondere einem Gewebe, Gewirke, Gestrick, Vlies, oder Vliesstoff.

Die Leiterbahnen sind insbesondere aufgedruckt, aufgeklebt, aufgedampft, aufgerakelt, aufgenäht, aufgestickt oder eingewoben.

Die Leiterbahnen können in Form von Drähten vorliegen. Sie können auch als Garne oder Zwirne ausgebildet sein, die einen metallischen Anteil enthalten, der hoch genug ist für die elektrische Leitung und zur Herstellung einer Lötverbindung. Das Garn kann ein rein metallischer Draht sein, ein Zwirn aus feinen Einzeldrähten, ein Zwirn aus Drähten und Polymerfasern, ein metallisch beschichteter Polymerfaden oder eine Kombination aus metallischen Drähten und/oder beschichteten Polymerfäden und/oder Polymerfasern.

Das leitfähige Garn kann einen Durchmesser aufweisen, der im Bereich von 10µm bis 2mm liegt, bevorzugt von 0.2mm bis 1mm.

Die Kontaktbereiche, an denen die Bauelemente an dem Substrat befestigt werden, müssen kompatibel mit der Ausgestaltung der Anschlussstellen der Bauelemente gestaltet werden. Bevorzugt werden die Leiterbahnen im Anschlussbereich mit einer Präzision von mindestens 2mm, besonders bevorzugt von mindestens 1mm, aufgebracht. Dies sind die typischen Toleranzen, die z.B. in einem textilen Prozess wie Sticken erreicht werden können.

Vorteilhafterweise sind die Kontaktbereiche, an denen die Bauelemente an dem Substrat befestigt sind, durch eine nichtleitende Schicht verstärkt. Insbesondere ist eine textile Verstärkung angebracht, zum Beispiel in Form eines mit einem nicht leitenden Faden flächig besticken Bereichs. Die Verstärkung macht die vorgesehenen Kontaktstellen vor dem Kontaktieren und Aufbringen deutlich sichtbar.

Die Verstärkung trägt ausserdem zur Stabilität der Verbindung zwischen Bauelement und Substrat bei. An der Verstärkung kann beispielsweise Wärme und/oder Druck beaufschlagt werden, die das unverstärkte Substrat beeinträchtigen könnten.

Die Klebeverbindung zwischen Bauelement und Anschlussstelle wird durch die Verstärkung ebenfalls begünstigt, insbesondere wenn das Substrat eine Beschaffenheit aufweist, die für eine Klebeverbindung, zum Beispiel chemisch oder mechanisch, ungünstig ist.

Vorteilhafterweise kann der Anschlussbereich eingefasst sein. Beispielsweise durch die weitere Aufbringung von nichtleitendem Materials. Die Dicke dieser Einfassung beträgt bevorzugt mindestens 0.2mm, besonders bevorzugt mindestens 0.5mm. Diese Einfassung bettet die Bauelemente besser in das Substrat ein und führt zu einer sensorisch und/oder haptisch homogeneren Oberfläche, sodass die Bauelemente nicht so stark gespürt werden.

Des Weiteren werden durch die Einfassung die kritischen und für einen Bruch unter mechanischer Belastung anfälligen Bereiche der elektrischen Verbindung zwischen Bauteilträger und Substrat, sowie der Rand des Bauteilträgers, mechanisch entlastet.

Die Aufgabe wird weiterhin gelöst durch ein Verfahren zum Applizieren eines Bauelements wie oben beschrieben auf einem flexiblen, textilen Substrat das durch die folgenden Verfahrensschritte gekennzeichnet ist. Es wird ein flexibles, textiles, Substrat mit Leiterbahnen zur Verfügung gestellt.
Das flexible Substrat wird bevorzugt als Meterware auf einer Rolle zur Verfügung gestellt.

Das Bauelement wird an einen gewünschten Kontaktbereich angelegt und anschliessend wird eine Klebe- und eine Lötverbindung hergestellt, insbesondere wird im Wesentlichen gleichzeitig Druck und/oder Wärme auf das Bauelement und/oder das Substrat aufgewendet und/oder ein elektromagnetisches Feld angelegt.

Das Verfahren wird bevorzugt auf einer, insbesondere modifizierten, Stickmaschine durchgeführt.

Im erfindungsgemässen Ausführungsverfahren wird die Lötverbindung durch ein punktuelles Erwärmen der Kanäle von der von dem Substrat abgewandten Seite des Bauelements hergestellt.

Die Wärme wird durch die Kanäle zu den Lotdepots geleitet, wodurch eine Lötverbindung zwischen dem Lotdepot und der Leitung hergestellt wird. Durch diese Lötverbindung werden die Bauteile elektrisch mit den Leitungen auf dem Substrat kontaktiert.

Das Erwärmen erfolgt im Wesentlichen nur über die Kanäle, so dass die Bauteile und die Verschaltung auf dem Bauteilträger nicht thermisch beeinträchtigt werden.

In einem alternativen bevorzugten Ausführungsverfahren wird die Lötverbindung durch ein induktives Erwärmen der Lotdepots hergestellt. Das Induktionsfeld wird bevorzugt mit einem Induktionslötwerkzeug auf der von dem Substrat abgewandten Seite des Bauelements erzeugt.

Das Substrat sowie die Bauteile werden keiner unnötigen und womöglich schädlichen Erwärmung ausgesetzt.

Die Lot- und Klebeverbindung kann besonders effektiv hergestellt werden, wenn der Kontaktbereich des Substrats und das Bauelement zwischen einer, insbesondere erwärmten, Pressvorrichtung gehalten werden.

In einer vorteilhaften Ausführung der Erfindung werden die Bauelemente als Platte, auf einem Band oder als Schüttgut zur Verfügung gestellt.

Die Bauelemente werden insbesondere mittels eines Pick- und Place- Werkzeugs einzeln an den jeweiligen vorgesehenen Kontaktbereich gebracht.

Bevorzugt wird das Bauelement relativ zum Substrat positioniert und orientiert. Alternativ kann das Substrat relativ zum Element ausgerichtet werden. Es kann auch eine Kombination von beiden vorliegen.

Vorteilhafterweise wird das Bauelement in einer bestimmten Orientierung gehalten und mittels einer optischen Orientierungshilfe die Kontaktbereiche auf dem Substrat relativ zum Bauelement positioniert.

Alternativ kann das Substrat fixiert werden und durch eine optische Orientierungshilfe werden die Kontaktbereiche auf dem Substrat identifiziert und die Bauelemente in korrekter Ausrichtung an die Kontaktstellen gebracht. Die Fixierung und Kontaktierung erfolgt durch Hitze und Druck.

Dabei kann zunächst eine Druckbeaufschlagung mit einer Temperatur und einem Druck, die geeignet sind, den Klebefilm zu aktivieren, auf das Bauelement und das Substrat gegeben werden. Hierbei kann es durch Verdrängung des Klebers schon zu einem mechanischen Kontakt zwischen den Lotdepots auf den Bauelementen und den Leitungen auf dem Substrat kommen.

Um diesen Kontakt noch zu verbessern, wird in einem zweiten Schritt von der zweiten Seite des Bauelements über die Kanäle lokal ausreichend Energie in Form von Wärme zugeführt, um das Lot der Lotdepots aufzuschmelzen und eine Lotverbindung zwischen dem Bauelement und den Leitungen auf dem Substrat herzustellen.

In einer anderen Ausführung wird in einem ersten Schritt zunächst durch geeigneten, lokal aufgewendeten Druck und lokal deponierte oder erzeugte Wärme eine Lötverbindung zwischen dem Lotdepots und den Leitungen auf dem Substrat hergestellt. Durch die lokale Erwärmung wird der Klebstoff, der sich gegebenenfalls auf den Lotdepots befindet, zersetzt oder aufgeweicht, sodass er durch den aufgewendeten Druck von den Lotdepots verdrängt wird, und eine gut leitende Verbindung zwischen dem Lotdepot und den Leitungen gewährleistet ist. Klebstoff, der sich in der Umgebung der Lotdepots befindet, wird schwächer erwärmt, so dass schon eine erste mechanische Verbindung zwischen dem Bauteilträger und dem Substrat hergestellt wird.

In einem zweiten Schritt wird mit einem geeigneten Verfahren Druck und Temperatur auf das Bauelement und das Substrat aufgebracht, um den Kleber zu aktivieren und eine flächige mechanische Verbindung zwischen den Bauelementen und dem Substrat herzustellen.

Da in einer bevorzugten Ausführung die Aktivierungstemperatur des Klebers unterhalb der des Lotes liegt, wird in diesem Prozessschritt die Lötverbindung nicht erneut aufgeschmolzen. Es besteht also keine Gefahr, die Lötverbindung wieder zu lösen. Zusätzlich wird durch die nur lokale Erwärmung der Kanäle die thermische Belastung auf des gesamten Bauelements minimiert, wodurch beispielsweise Lacke geschont werden und das Entstehen von Verfärbungen verhindert wird.

In einer besonders bevorzugten Ausführung findet der Prozess des Klebens und Lötens in einem kombinierten Prozessschritt statt. Zum einen werden das Bauelement und das Substrat grossflächig mit Druck und Temperatur beaufschlagt, die ausreichen, um den Kleber zu aktivieren und eine Verbindung zwischen Bauelement und Substrat herzustellen. Parallel dazu wird punktuell über die Kanäle oder induktiv Wärme hinzugeführt, um die Lotdepots aufzuschmelzen und eine elektrische Verbindung zwischen den Bauteilen und den Leitungen des Substrats herzustellen. Insbesondere kann die punktuell zugeführte oder erzeugte Wärme ausreichen, um das gesamte Element ausreichend für eine Klebeaktivierung zu erwärmen, so dass flächig nur Druck auf das Element gegeben werden muss. Die Druckbeaufschlagung kann durch ein Druckelement aus einem thermisch isolierenden Material erfolgen.

In einer vorteilhaften Ausführung des Verfahrens werden mehrere separate Bauelemente gleichzeitig auf ein Substrat aufgebracht und befestigt.

In einer vorteilhaften Ausführung des Verfahrens wird das bestückte Substrat in einem nachfolgenden Schritt weiterbehandelt. Die Verbindung zwischen Bauelement und Substrat ist so robust, dass das bestückte Substrat in einem nachfolgenden Verfahrensschritt zum Beispiel gewaschen, gefärbt, imprägniert und/oder bedruckt werden kann.

Die Aufgabe wird weiterhin gelöst durch eine nicht erfindungsgemässe Vorrichtung zum Applizieren eines Bauelements wie oben beschrieben auf ein flexibles, textiles Substrat. Dazu weist die nicht erfindungsgemässe Vorrichtung eine Heizvorrichtung zur punktuellen Erwärmung der Lotdepots und der Kanäle von der dem Substrat abgewandten Seite des Bauelements auf. Weiterhin weist die nicht erfindungsgemässe Vorrichtung bevorzugt eine erwärmbare Anpressvorrichtung zur Herstellung einer Klebeverbindung zwischen Bauelement und Substrat auf.

Bei der Heizvorrichtung kann es sich um eine Vorrichtung mit einem Lötkolben, einem Mikroflammlötgerät, einem Laserlötgerät, einem Laserschweissgerät oder einem Lötstempel handeln. Bevorzugt handelt es sich um ein Gerät zum Bügellöten.

Insbesondere können mit der Heizvorrichtung mehrere Kanalenden gleichzeitig punktuell erwärmt werden.

Alternativ kann es sich um ein Induktionslötwerkzeug handeln, mit dem der elektromagnetische Induktionseffekt zur Wärmeerzeugung genutzt wird. Das Induktionslötwerkzeug in Form eines Induktors kann durch eine geschickte Formgebung gezielt nur die Lötstelle erhitzen.

Der Induktor ist so gestaltet, dass er an die Grösse und Lage der Lotdepots angepasst ist und dass durch das magnetische Wechselfeld die auf dem Bauelement angeordneten Bauteile nicht beeinträchtigt werden. Insbesondere werden in den Bauteilen keine elektrischen Spannungen induziert, die groß genug sind, um die elektronischen Bauteile beschädigen zu können.

Bei der Anpressvorrichtung kann es sich um einen Heizstempel, um eine Heisspresse, um eine Bandpresse oder ein Bügeleisen handeln. Der Druck kann durch ein Federmechanismus, ein Linearmotor oder ein pneumatisches System aufgebracht werden.

Vorzugsweise weist die nicht erfindungsgemässe Vorrichtung mindestens ein Zuführungswerkzeug, wie ein Pick-and-Place Werkzeug oder ein vergleichbares Werkzeug, zum Heranbringen des Bauelements an das Substrat auf.

Mit der nicht erfindungsgemässen Vorrichtung kann das Aufbringen der Bauteile auf das Substrat automatisiert erfolgen, insbesondere auf einer modifizierten Stickmaschine.

Die Erfindung betrifft ausserdem textile Produkte, die aus Bauelementanordnungen wie oben beschrieben gefertigt sind. Dazu gehören Dekorationstextilien, wie zum Beispiel Vorhänge, Gardinen, Wandbehänge, Bettüberwürfe, Bezugsstoffe für Sitze, Möbel, und Bettwaren, Kleidungsstücke, insbesondere Dessous, Kleider, Umhänge, Theater- und Fastnachtskostüme, Sportbekleidung, Funktions- und Berufsbekleidung, sowie technische Textilien für Mobilitäts-, Medizinal-, Architektur- und Industrieanwendungen. Die textilen Produkte tragen Bauelemente, auf denen zum Beispiel Sensoren, Signalgeber, Stromquellen, Stromspeicher, Solarzellen und/oder Verarbeitungseinheiten angebracht sind.

Die Erfindung wird nachfolgend an Hand von Ausführungsbeispielen näher erläutert.

Es zeigen
- Figur 1: eine schematische Schnittdarstellung eines erfindungsgemässen Bauelements;
- Figur 2: eine schematische Darstellung in Draufsicht auf die dem Substrat zuzuwendende Oberfläche des erfindungsgemässen Bauelements;
- Figur 3: eine schematische Darstellung in Draufsicht auf die von dem Substrat abzuwendende Oberfläche des erfindungsgemässen Bauelements;
- Figur 4: eine schematische Darstellung in Draufsicht einer erfindungsgemässen Bauelementanordnung;
- Figur 5: eine schematische Schnittdarstellung einer erfindungsgemässen Bauelementanordnung;
- Figur 6: eine schematische Schnittdarstellung eines weiteren Beispiels für ein Bauelement;
- Figur 7a: eine schematische Schnittdarstellung eines Beispiels für einen Kanal;
- Figur 7b: eine schematische Schnittdarstellung eines weiteren Beispiels für einen Kanal;
- Figur 8: eine schematische Darstellung in Draufsicht eines ersten Beispiels für ein vorbereitetes Substrat;
- Figur 9: eine schematische Darstellung in Draufsicht eines zweiten Beispiels für ein vorbereitetes Substrat;
- Figur 10: eine schematische Schnittdarstellung einer weiteren Bauelementanordnung mit Einfassung;
- Figur 11: eine schematische Darstellung in Draufsicht einer Bauteilträgerplatte zur Fertigung eines erfindungsgemässen Bauelements.

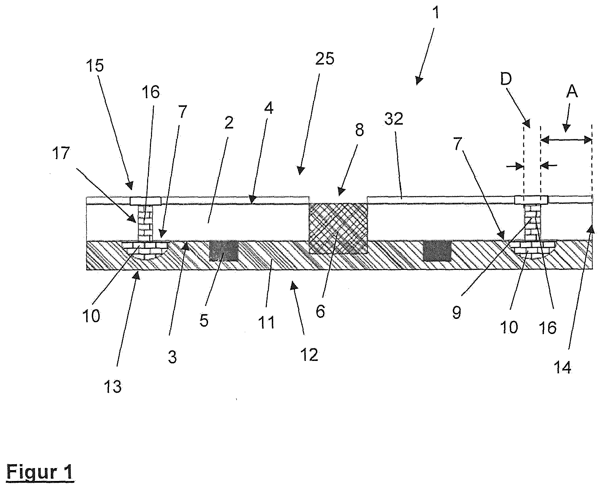

Figur 1 zeigt eine schematische Schnittdarstellung eines erfindungsgemässen Bauelements 1. Das Bauelement 1 umfasst einen Bauteilträger 2 mit einer ersten Oberfläche 3, die dem in der Figur nicht explizit gezeigte Substrat zuzuwenden ist, und eine der ersten Oberfläche 3 gegenüberliegenden zweiten Oberfläche 4.

Das Bauelements 1 umfasst weiterhin auf dem Bauteilträger montierte Bauteile 5, 6, die mit Strom und/oder Spannung beaufschlagbar sind.

Ein zentral angeordnetes Bauteil 6 ist als sogenanntes "reversemount" - Bauteil auf dem Bauteilträger 2 angebracht. Es ist an der ersten Oberfläche 3 mit den übrigen Bauteilen 5 und Kontaktstellen 7 leitend kontaktiert, ist jedoch so an einer Ausnehmung 8 im Bauteilträger 2 angebracht, dass es seine Funktion an der zweiten Oberfläche 4 entfalten kann. Bei dem "reverse-mount"-Bauteil 6 handelt es sich zum Beispiel um eine LED, die von dem nicht dargestellten Substrat weg leuchtet.

Der Bauteilträger 2 weist zwei thermisch leitfähige Kanäle 9 auf, welche von der ersten Oberfläche 3 zur zweiten Oberfläche 4 führen. Diese sind jeweils thermisch leitend mit einem Lotdepot 10 verbunden, welches auf der ersten Oberfläche 3 des Bauteilträgers 2 angeordnet sind.

Die erste Oberfläche 3 des Bauteilträgers 2 ist teilweise mit einem Klebestoff 11 überzogen. Im gezeigten Beispiel ist die dem Substrat zuzuwendende Seite 12 des Bauelements 1 komplett mit einem Klebefilm 13 überzogen, somit sind auch die Lotdepots 10 von dem Klebefilm 13 bedeckt.

Die Kanäle 9 weisen Durchmesser D von 0.1mm bis 2mm auf und haben vom Rand 14 des Bauteilträgers 2 einen Abstand A von 0.1-1mm.

Die Kanäle 9 sind auf der von dem Substrat abzuwendenden Seite 25 des Bauelements 1 mit einer Abdeckung 15, z.B. einer Kupferschicht, versehen.

Die Kanäle 9 sind mit Lot 16 gefüllte Ausnehmungen 17, wobei das Lot 16 jeweils in Verbindung mit einem Lotdepot 10 steht.

Die vom Substrat abzuwendende Oberfläche 4 des Bauelements 1 ist zumindest in der Umgebung der Kanäle 9 mit einem Lötstopplack 32 überzogen.

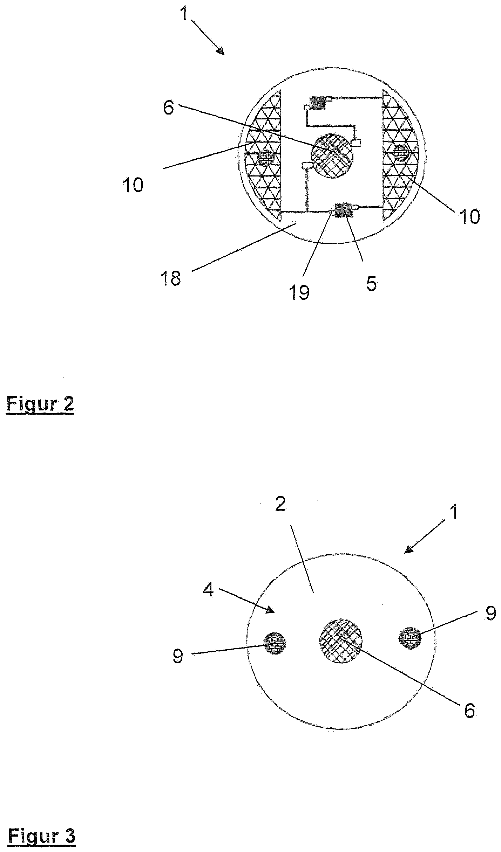

Figur 2 zeigt eine schematische Darstellung in Draufsicht auf die dem nicht explizit dargestellten Substrat zuzuwendende Oberfläche des erfindungsgemässen Bauelements 1.

Die Lotdepots 10 des Bauelements 1 sind über Leiterbahnen 18 elektrisch leitend mit den Bauteilen 5, 6 verbunden. An den Bauteilen 5, 6 sind überdies Lötpads 19 vorgesehen, welche eine Kontaktierung zwischen den Leiterbahnen 18 und den Bauteilen 5, 6 herstellen.

Figur 3 zeigt eine schematische Darstellung in Draufsicht auf die von dem nicht explizit dargestellten Substrat abzuwendende Oberfläche des erfindungsgemässen Bauelements 1.

Die in dieser Figur nicht sichtbaren Lotdepots 10 können erwärmt werden, indem dem Bauelement 1 an den auf der zweiten Oberfläche 4 des Bauteilträgers 2 endenden Kanälen 9 punktuell Wärme zugeführt wird.

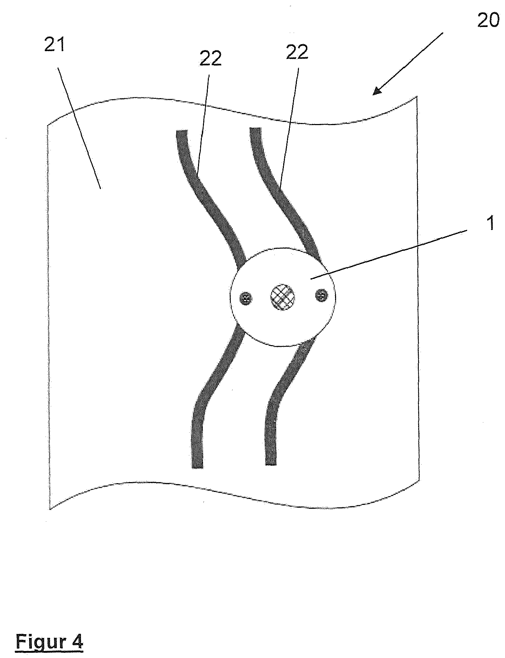

Figur 4 zeigt eine schematische Darstellung in Draufsicht einer erfindungsgemässen Bauelementanordnung 20.

Die Bauelementanordnung 20 umfasst ein flexibles Substrat 21 mit Leiterbahnen 22 und ein Bauelement 1.

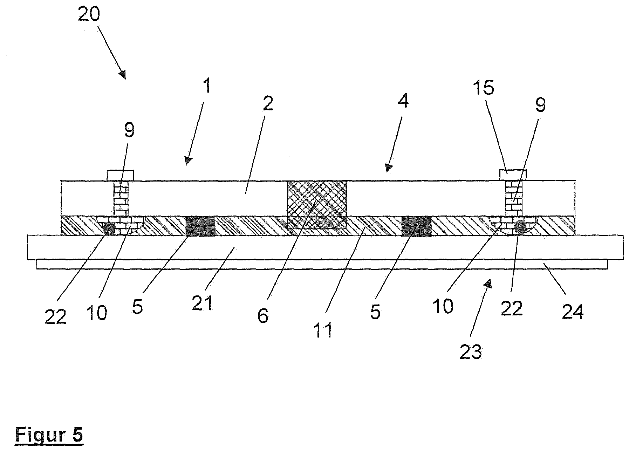

Figur 5 zeigt eine schematische Schnittdarstellung der erfindungsgemässen Bauelementanordnung 20.

Die Lotdepots 10 des Bauelements 1 sind mit je einer Leiterbahn 21 elektrisch leitend verbunden und zwischen dem Bauteilträger 2 und dem Substrat 21 besteht über den Klebestoff 11 ein Klebekontakt.

Werden die Kanäle 9 punktuell von der zweiten Oberfläche 4 aus erwärmt, wird die Wärme weiter zu den Lotdepots 10 geleitet, die aufschmelzen und einen soliden elektrischen Kontakt mit den auf dem Substrat 21 angebrachten Leiterbahnen 22 eingehen.

Der Klebstoff 11 wird dabei von den Lotdepots 10 verdrängt, so dass er der elektrischen Verbindung nicht im Wege steht. Andererseits haftet der Klebstoff 11 sowohl am Bauteilträger 2, an den Bauteilen 5, 6 und am Substrat 21, sodass zwischen dem Bauelement 1 und dem Substrat 21 auch eine robuste mechanische Verbindung besteht.

Das Substrat 21 ist auf der vom Bauteil 1 abgewandten Seite mit einer nicht leitenden, insbesondere textilen, Schicht 24 versehen.

Dadurch wird insbesondere der Kontaktbereich 23, an welchem das Bauelement 1 an dem Substrat 21 befestigt ist, verstärkt. Die Schicht 24 kann aufgesprüht, aufgestrichen, aufgeklebt oder, insbesondere im Kontaktbereich 23, aufgenäht oder aufgestickt sein.

Die Schicht 24 stabilisiert den Kontaktbereich 23 und schützt das Substrat vor Beeinträchtigung durch Wärme- und/oder Druckbeaufschlagung.

Die von der dem Substrat 21 abgewandte zweite Oberfläche 4 des Bauteilträgers 2 kann zwischen den Abdeckungen 15 und dem Bauteil 6 mit einem nicht explizit gezeigten Lötstopplack bedeckt sein.

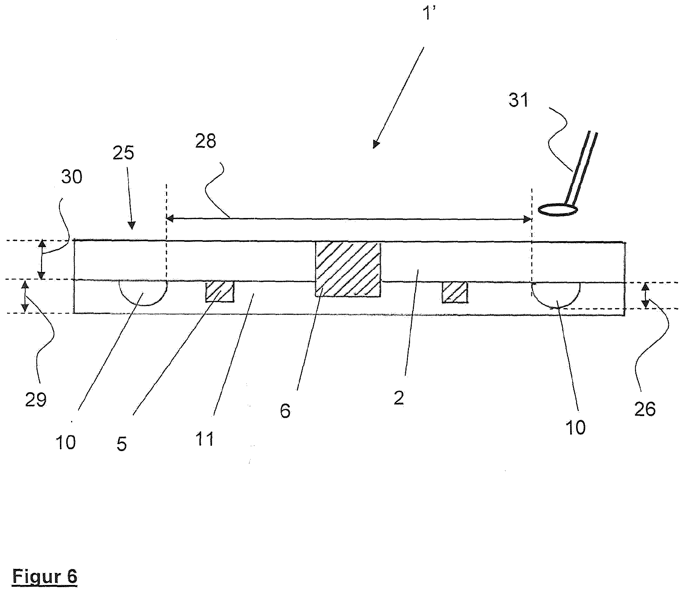

Figur 6 zeigt eine schematische Schnittdarstellung eines zweiten Beispiels für ein Bauelement 1'. Das Bauelement 1' umfasst ebenfalls einen Bauteilträger 2 mit einer ersten Oberfläche 3, die dem in der Figur nicht explizit gezeigte Substrat zuzuwenden ist, und eine der ersten Oberfläche 3 gegenüberliegenden zweiten Oberfläche 4.

Das Bauelements 1' umfasst weiterhin auf dem Bauteilträger 2 montierte Bauteile 5, 6, die mit Strom und/oder Spannung beaufschlagbar sind.

Auf der dem Substrat zuzuwenden Fläche Oberfläche 3 sind Lotdepots 10 und Klebstoff 13 angebracht.

Die Schichtdicke 26 der Lotdepots 10 beträgt bevorzugt 0.01-1mm, weiter bevorzugt 0.05-0.5mm, sodass genügend Lot vorhanden ist, um eine zuverlässige elektrische Verbindung zu den hier nicht explizit dargestellten Leiterbahnen 22 auf dem Substrat herzustellen.

Die Lotdepots 10 weisen vom Rand des Bauelements 1' einen abstand 27 auf, der bevorzugt mindestens 0.1mm, weiter bevorzugt von mindestens 0.2mm, beträgt.

Die Lotdepots 10 sind voneinander beabstandet, wobei bevorzugt jeweils der Abstand 28 zum nächsten Lotdepot 10 mindestens 0.3mm, weiter bevorzugt von mindestens 0.5mm, weiter bevorzugt von mindestens 1mm, beträgt.

Der Klebstoff ist bevorzugt mit einer Schichtdicke aufgebracht, die vorteilhafterweise im Bereich 0.01-0.5mm, bevorzugt im Bereich 0.05-0.2mm, liegt.

Der Bauteilträger 2 weist eine Materialstärke 30 auf, die bevorzugt im Bereich von 10 µm bis 2000 µm, weiter bevorzugt von 100 µm bis 1000 µm liegt.

Die Lotdepots 10 können punktuell und berührungsfrei mittels eines Induktionslötwerkzeugs 32 erwärmt und verflüssigt werden.

Dazu wird zum Beispiel das Induktionslötwerkzeugs 32 in Form eines Induktors über der Lötstelle, also über dem Lotdepot 10 positioniert. Bevorzugt wird das Induktionslötwerkzeugs 32 auf der von dem Substrat abzuwendenden Seite 25 des Bauelements 1' positioniert.

Nachdem der Induktor eingeschaltet wurde, wird das Lotdepot über ein Hochfrequenzfeld berührungslos mit einer vorgewählten, an die Lotmenge angepassten Leistung aufgeheizt. Es wird sichergestellt, dass das Lot an der Kontaktstelle verläuft und einen Meniskus um die Leiterbahn bildet.

Bevorzugt ist der Induktor so ausgelegt, dass das Hochfrequenzfeld im Wesentlichen am Ort der Lotdepots entsteht und die übrigen Bauteile 5, 6 unbeeinträchtigt bleiben.

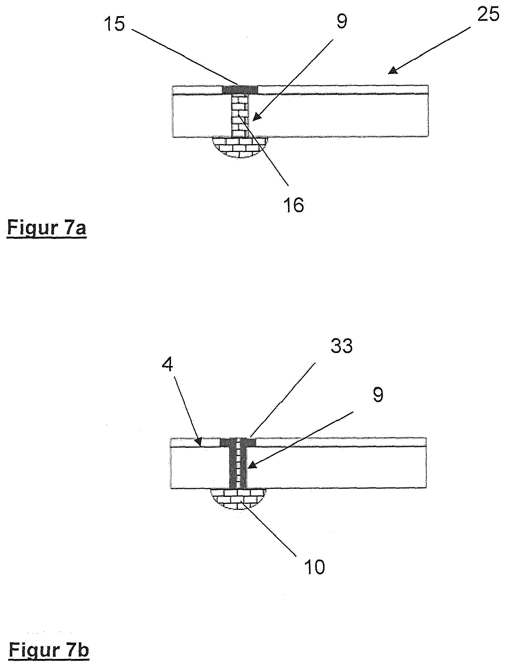

Bei einem erfindungsgemässes Bauelement 1 mit Kanälen 9, können, wie es in den Figuren 1 und 7a gezeigt ist, die Kanäle 9 mit Lot 16 gefüllt sein und auf der vom Substrat abzuwendenden Seite 25 mit einer Abdeckung 15 versehen sein.

Alternativ kann, wie in Figur 7b gezeigt ist, ein Kanal 9 mit einer leitfähigen Schicht 33 ausgekleidet sein, die sich bis an die zweite Oberfläche 4 fortsetzt.

Die Lotdepots 10 können erwärmt werden, indem von der vom Substrat abzuwendenden Seite 25 entweder die Abdeckung 25 oder die leitfähige Schicht punktuell erhitzt wird, zum Beispiel durch Kontakt mit einem Lötwerkzeug.

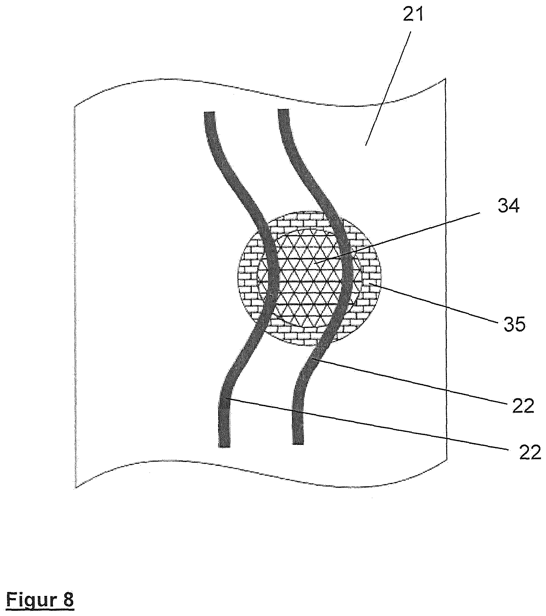

Figur 8 zeigt eine schematische Darstellung in Draufsicht eines ersten Beispiels für ein vorbereitetes Substrat 21. Auf dem Substrat werden zunächst eine textile Verstärkung 34 und eine textile Einfassung 35 angebracht, beispielweise aufgestickt, aufgenäht oder aufgeklebt.

In einem nachfolgenden Schritt werden die Leiterbahnen 22 aufgebracht, beispielsweise durch Sticken eines entsprechend leitfähigen Fadens.

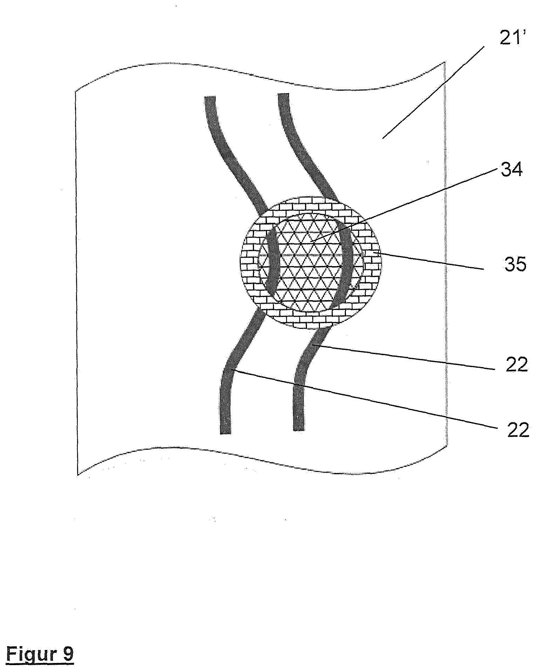

Figur 9 zeigt eine schematische Darstellung in Draufsicht eines zweiten Beispiels für ein vorbereitetes Substrat 21'.

In diesem Fall wurden zunächst die textile Verstärkung 24, dann die Leiterbahnen 22 und anschliessend die Einfassung 35 angebracht.

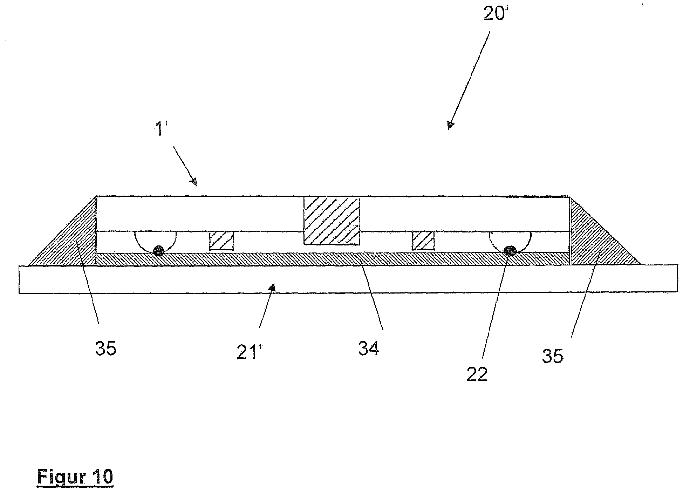

Figur 10 zeigt eine schematische Schnittdarstellung einer Bauelementanordnung 20' mit textiler Einfassung 35. Das Substrat 21', ist mit einer textilen Verstärkung 34 versehen, über welche die Leiterbahnen 22 verlaufen und auf welcher ein Bauelement 1' angebracht ist. Auf dem Substrat 21' ist ausserdem eine textile Einfassung 35 vorgesehen. Sie umgibt das Bauelement 1' und stabilisier es seitlich. Die Einfassung 35 sorgt für einen weniger abrupten Übergang von der Kante des Bauelements zur Oberfläche des Substrats 1' und damit für eine insgesamt glattere Oberfläche.

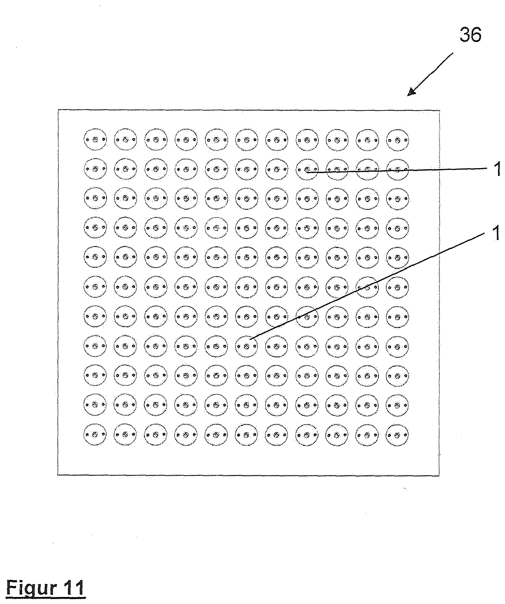

Figur 11 zeigt eine schematische Darstellung in Draufsicht einer Bauteilträgerplatte 36 zur Fertigung eines erfindungsgemässen Bauelements 1.

Bevorzugt werden Lotdepots, Bauteile, Leitungen und dergleichen auf einer Platte aus Trägermaterial angeordnet und so eine Bauteilträgerplatte 36 erstellt.

Abschliessend werden die jeweiligen Bauelemente 1 vereinzelt.

## Patentansprüche

1. Bauelement zum Anbringen auf ein flexibles, textiles Substrat (21)
umfassend einen Bauteilträger (2) mit
einer ersten dem Substrat (21, 21') zuzuwendenden Oberfläche (3),
einer, bevorzugt der ersten Oberfläche (3) gegenüberliegenden, zweiten Oberfläche (4),
mindestens ein auf dem Bauteilträger (2) montiertes Bauteil (5, 6), das mit Strom und/oder Spannung beaufschlagbar ist, und mindestens zwei Lotdepots (10) welche auf der ersten Oberfläche (3) des Bauteilträgers (2) angeordnet sind, **dadurch gekennzeichnet, dass**
der Bauteilträger (2) mindestens zwei thermisch leitfähige Kanäle (9) aufweist, welche von der ersten Oberfläche (3) zur zweiten Oberfläche (4) führen, die jeweils thermisch leitend mit mindestens einem der mindestens zwei Lotdepots (10) verbunden sind,
wobei die Kanäle (9) insbesondere zumindest teilweise mit Lot (16) gefüllte Ausnehmungen (17) sind, und wobei die erste Oberfläche (3) des Bauteilträgers (2) zumindest teilweise mit einem, insbesondere thermisch aktivierbaren und/oder thermisch aushärtbaren, Klebestoff (11), insbesondere einem Klebefilm (13), überzogen ist, wobei insbesondere die Lotdepots (10) mit Klebefilm (13) überzogen sind.

2. Bauelement gemäss Anspruch 1, **dadurch gekennzeichnet, dass** das Bauelement (1) mindestens eine der folgenden Eigenschaften a)- h) aufweist,
a) jedes Lotdepot (10) weist eine dem Substrat (21) zuwendenden Fläche auf, deren Grösse in einem Bereich zwischen 0.2 mm² bis 100 mm², bevorzugt zwischen 0.5 mm² und 50 mm², weiter bevorzugt zwischen 1 mm² und 10 mm² liegt,
b) die Schichtdicke (26) der Lotdepots (10) beträgt 0.01-1mm, bevorzugt 0.05-0.5mm,
c) jedes Lotdepot (10) hat vom Rand des Bauteilträgers (2) einen Abstand (27) von mindestens 0.1mm, bevorzugt von mindestens 0.2mm,
d) jedes Lotdepot (10) hat von jedem anderen Lotdepot (10) einen Abstand (28) von mindestens 0.3mm, bevorzugt von mindestens 0.5mm, weiter bevorzugt von mindestens 1mm,
e) mindestens 50%, weiter bevorzugt mindestens 70%, weiter bevorzugt mindestens 80%, der ersten Oberfläche (3) sind mit Klebstoff überzogen, insbesondere ist die dem Substrat (21, 21') zuzuwendende Seite (12) des Bauelements (1) mit Klebstoff (11) überzogen,
f) die Dicke (29) des Klebestoffs (11) liegt im Bereich 0.01-0.5mm, bevorzugt 0.05-0.2mm,
g) das Flächengewicht des Klebstoffs (11) liegt im Bereich von 10-500 g/m², bevorzugt 20-200 g/ m², bevorzugt 50-100 g/m²,
h) der Bauteilträger (2) hat eine Materialstärke (30) im Bereich von 10 µm bis 2000 µm, bevorzugt von 100 µm bis 1000 µm.

3. Bauelement gemäss Anspruch 1 oder 2, **dadurch gekennzeichnet, dass**
die Kanäle (9) jeweils einen Durchmesser (D) haben, der in einem Bereich von 0.1mm bis 2mm liegt, bevorzugt von 0.2mm bis 1mm liegt, und/oder
die Kanäle (9) jeweils einen Abstand von mindestens 0,1mm, bevorzugt von mindestens 0.5mm, vom Rand des Bauteilträgers (2) haben.

4. Bauelement gemäss einem der Ansprüche 1 bis 3, **dadurch gekennzeichnet, dass** die Kanäle (9) an der zweiten Oberfläche (4), mit einer Abdeckung (15), z.B. einer Kupferschicht, versehen sind.

5. Verfahren zur Herstellung eines Bauelements gemäss einem der Ansprüche 1 bis 4 umfassend die folgenden Verfahrensschritte
- Bestücken eines Bauteilträgers (2) mit mindestens einem Bauteil (5, 6);
- Anbringen von mindestens zwei thermisch leitfähigen Kanälen (9), die jeweils von einer ersten Seite (3) des Bauteilträgers (2) zu einer zweiten Seite (4) des Bauteilträgers (2) führen, insbesondere Bereitstellen von durchgehenden Ausnehmungen (17) und Einfüllen von Lot (16), wobei insbesondere die Innenwandungen der Kanäle (9) leitfähig beschichtet werden, insbesondere vor den Füllen mit Lot;
- mindestens zwei Lotdepots (10) auf der ersten Seite (3) des Bauteilträgers (2) anbringen;
- Klebstoff (11) auf eine dem Substrat (21) zuzuwendende Seite (12) des Bauelements (1) auftragen.

6. Verfahren gemäss Anspruch 5, **dadurch gekennzeichnet, dass** das Bauelement (1, 1') mindestens eine der folgenden Eigenschaften a)- h) aufweist,
a) jedes Lotdepot (10) weist eine dem Substrat (21, 21') zuzuwendenden Fläche auf, deren Grösse in einem Bereich zwischen 0.2 mm² bis 100 mm², bevorzugt zwischen 0.5 mm² und 50 mm², weiter bevorzugt zwischen 1 mm² und 10 mm² liegt,
b) die Schichtdicke (26) von jedem Lotdepots (10) beträgt 0.01-1mm, bevorzugt 0.05-0.5mm,
c) jedes Lotdepot (10) hat vom Rand des Bauteilträgers (2) einen Abstand (27) von mindestens 0.1mm, bevorzugt von mindestens 0.2mm,
d) jedes Lotdepot (10) hat von jedem anderen Lotdepot (10) einen Abstand (28) von mindestens 0.3mm, bevorzugt von mindestens 0.5mm, weiter bevorzugt von mindestens 1mm,
e) mindestens 50%, weiter bevorzugt mindestens 70%, weiter bevorzugt mindestens 80%, der ersten Oberfläche (3) sind mit Klebstoff (11) überzogen,
f) die Dicke (29) des Klebestoffs (11) liegt im Bereich 0.01-0.5mm, bevorzugt 0.05-0.2mm,
g) das Flächengewicht des Klebstoffs (11) liegt im Bereich von 10-500 g/m², bevorzugt 20-200 g/m², bevorzugt 50-100 g/m²,
h) der Bauteilträger (2) hat eine Materialstärke (30) im Bereich von 10 µm bis 2000 µm, bevorzugt von 100 µm bis 1000 µm.

7. Verfahren gemäss Anspruch 5, **dadurch gekennzeichnet, dass** die Kanäle (9) jeweils einen Durchmesser (D) haben, der in einem Bereich von 0.1mm bis 2mm liegt, bevorzugt von 0.2mm bis 1mm liegt, und/oder
die Kanäle (9) jeweils einen Abstand von mindestens 0,1mm, bevorzugt von mindestens 0.5mm, vom Rand des Bauteilträgers (2) haben.

8. Bauelementanordnung, umfassend ein flexibles, textiles Substrat (21, 21') mit Leiterbahnen (22) und mindestens einem Bauelement (1, 1') gemäss einem der Ansprüche 1 bis 4, **dadurch gekennzeichnet, dass** mindestens zwei Lotdepots (10) des Bauelements (1, 1') mit je einer Leiterbahn (22) elektrisch leitend verbunden sind und ein Klebekontakt zwischen dem Bauteilträger (2) und dem Substrat (21, 21') besteht.

9. Bauelementanordnung gemäss Anspruch 8, **dadurch gekennzeichnet, dass** das Substrat (21, 21'), zumindest in den Kontaktbereichen (23), an denen die Bauelemente (1, 1') an dem Substrat (21, 21') befestigt sind, durch eine nicht leitende Schicht (24) verstärkt ist, insbesondere eine textile Verstärkung (34) und/oder eine textile Einfassung (35) angebracht ist.

10. Verfahren zum Applizieren eines Bauelements gemäss einem der Ansprüche 1 bis 4 auf einem flexiblen, textilen Substrat, umfassend die folgenden Verfahrensschritte
- zur Verfügung stellen eines flexiblen, textilen Substrats (21, 21') mit Leiterbahnen (22);
- Anlegen des Bauelements (1) an einen gewünschten Kontaktbereich (23);
- Herstellen einer Klebe- und einer Lötverbindung, insbesondere im Wesentlichen gleichzeitiges Aufwenden von Druck, Wärme und/oder eines elektromagnetischen Feldes auf das Bauelement (1), wobei die Lötverbindung durch ein punktuelles Erwärmen von Kanälen (9) von der dem Substrat (21) abgewandten Seite (4) des Bauelements (1) hergestellt wird.

11. Verfahren gemäss Anspruch 10, **dadurch gekennzeichnet, dass** die Lötverbindung durch ein induktives Erwärmen der Lotdepots, insbesondere von der dem Substrat (21, 21') abgewandten Seite (4) des Bauelements (1, 1'), hergestellt wird.

12. Verfahren gemäss Anspruch 10 oder 11, **dadurch gekennzeichnet, dass** der Kontaktbereich (23) und das Bauelement (1) zwischen einer, insbesondere erwärmten, Pressvorrichtung gehalten werden.

13. Verfahren gemäss Anspruch 10 bis 12, **dadurch gekennzeichnet, dass** mehrere Lötverbindungen gleichzeitig hergestellt werden.

14. Verfahren gemäss einem der Ansprüche 10 bis 13, **dadurch gekennzeichnet, dass** die Bauelemente (1, 1') auf einer Platte, auf einem Band oder als Schüttgut zur Verfügung gestellt werden und insbesondere von einem Werkzeug, zum Beispiel einem Pick-and-Place Werkzeug, entnommen und an den Kontaktbereich (23) gebracht werden.

15. Verfahren gemäss einem der Ansprüche 10 bis 14 **dadurch gekennzeichnet, dass** in einem nachfolgenden Schritt das bestückte Substrat (21, 21') weiterbehandelt wird, zum Beispiel bedruckt wird.

## Claims

1. Component for mounting on a flexible textile substrate (21) comprising a component carrier (2) with
a first surface (3) facing the substrate (21, 21'),
a second surface (4), preferably opposite the first surface (3),
at least one member (5, 6) which is mounted on the component carrier (2) and to which current and/or voltage can be applied,
and at least two solder depots (10) which are arranged on the first surface (3) of the component carrier (2), **characterised in that**
the component carrier (2) has at least two thermally conductive channels (9) which lead from the first surface (3) to the second surface (4) and which are each thermally conductively connected to at least one of the at least two solder deposits (10),
wherein the channels (9) are in particular recesses (17) at least partially filled with solder (16), and wherein the first surface (3) of the component carrier (2) is at least partially coated with an adhesive (11), which in particular can be thermally activated and/or thermally cured, in particular an adhesive film (13), , wherein in particular the solder deposits (10) are coated with adhesive film (13).

2. Component according to claim 1, **characterized in that** the component (1) has at least one of the following properties a)-h),
a) each solder depot (10) has a surface facing the substrate (21), the size of which lies in a range between 0.2 mm² and 100 mm², preferably between 0.5 mm² and 50 mm2, further preferably between 1 mm² and 10 mm²,
b) the layer thickness (26) of the solder depots (10) is 0.01-1mm, preferably 0.05-0.5mm
c) each solder depot (10) has a distance (27) of at least 0.1mm, preferably at least 0.2mm, from the edge of the component carrier (2),
d) each solder depot (10) has a distance (28) from each other solder depot (10) of at least 0.3mm, preferably at least 0.5mm, more preferably at least 1mm,
e) at least 50%, further preferably at least 70%, further preferably at least 80%, of the first surface (3) are coated with adhesive, in particular the side (12) of the component (1) facing the substrate (21, 21') is coated with adhesive (11),
f) the thickness (29) of the adhesive (11) is in the range 0.01-0.5mm, preferably 0.05-0.2mm,
(g) the grammage of the adhesive (11) is in the range 10-500 g/m², preferably 20-200 g/m², preferably 50-100 g/m²,
h) the component carrier (2) has a material thickness (30) in the range of 10 µm to 2000 µm, preferably from 100 µm to 1000 µm.

3. Component according to claim 1 or 2, **characterized in that** the channels (9) each have a diameter (D) which lies in a range from 0.1mm to 2mm, preferably from 0.2mm to 1mm, and/or the channels (9) each have a distance of at least 0.1 mm, preferably at least 0.5 mm, from the edge of the component carrier (2).

4. Component according to one of claims 1 to 3, **characterised in that** the channels (9) are provided on the second surface (4) with a cover (15), e.g. a copper layer.

5. Method for producing a component according to one of claims 1 to 4, comprising the following steps
- Equipping a component carrier (2) with at least one member (5, 6);
- attaching at least two thermally conductive channels (9), which each lead from a first side (3) of the component carrier (2) to a second side (4) of the component carrier (2), in particular providing continuous recesses (17) and filling with solder (16), wherein in particular the inner walls of the channels (9) are conductively coated, in particular before filling with solder;
- applying at least two solder deposits (10) on the first side (3) of the component carrier (2);
- applying adhesive (11) to a side (12) of the component (1) facing the substrate (21).

6. Method according to claim 5, **characterized in that** the component (1, 1') has at least one of the following properties a) - h),
a) each solder depot (10) has a surface to be turned towards the substrate (21, 21'), the size of which lies in a range between 0.2 mm2 and 100 mm², preferably between 0.5 mm² and 50 mm2, further preferably between 1 mm² and 10 mm²,
b) the layer thickness (26) of each solder depot (10) is 0.01-1mm, preferably 0.05-0.5mm
c) each solder depot (10) has a distance (27) of at least 0.1mm, preferably at least 0.2mm, from the edge of the component carrier (2),
d) each solder depot (10) has a distance (28) from each other solder depot (10) of at least 0.3mm, preferably at least 0.5mm, more preferably at least 1mm,
e) at least 50%, more preferably at least 70%, more preferably at least 80%, of the first surface (3) is coated with adhesive (11),
f) the thickness (29) of the adhesive (11) is in the range 0.01-0.5mm, preferably 0.05-0.2mm,
(g) the grammage of the adhesive (11) is in the range 10-500 g/m², preferably 20-200 g/m², preferably 50-100 g/m²,
h) the component carrier (2) has a material thickness (30) in the range of 10 µm to 2000 µm, preferably from 100 µm to 1000 µm.

7. Method according to claim 5, **characterised in that** the channels (9) each have a diameter (D) which lies in a range from 0.1mm to 2mm, preferably from 0.2mm to 1mm, and/or
the channels (9) each have a distance of at least 0.1 mm, preferably at least 0.5 mm, from the edge of the component carrier (2).

8. Component-arrangement, comprising a flexible, textile substrate (21, 21') with conductor tracks (22) and at least one component (1, 1') according to one of claims 1 to 4, **characterized in that** at least two solder depots (10) of the component (1, 1') are each electrically conductively connected to a conductor track (22) and an adhesive contact exists between the component carrier (2) and the substrate (21, 21').

9. Component-arrangement according to claim 8, **characterized in that** the substrate (21, 21'), at least in the contact areas (23) where the components (1, 1') are attached to the substrate (21, 21'), is reinforced by a non-conductive layer (24), in particular a textile reinforcement (34) and/or a textile edging (35) is applied.

10. Method for applying a component according to one of claims 1 to 4 to a flexible, textile substrate, comprising the following method steps
- providing a flexible, textile substrate (21, 21') with conductive tracks (22);
- applying the component (1) to a desired contact area (23);
- producing an adhesive and a solder connection, in particular substantially simultaneously applying pressure, heat and/or an electromagnetic field to the component (1), the solder connection being produced by punctual heating of channels (9) from the side (4) of the component (1) facing away from the substrate (21).

11. Method according to claim 10, **characterized in that** the solder connection is produced by inductive heating of the solder deposits, in particular from the side (4) of the component (1, 1') facing away from the substrate (21, 21').

12. Method according to claim 10 or 11, **characterized in that** the contact area (23) and the component (1) are held between a, in particular heated, pressing device.

13. Method according to claims 10 to 12, **characterised in that** several soldered connections are produced simultaneously.

14. Method according to one of claims 10 to 13, **characterized in that** the components (1, 1') are provided on a plate, on a belt or as bulk material and are in particular removed from a tool, for example a pick-and-place tool, and brought to the contact area (23).

15. Method according to one of claims 10 to 14, **characterised in that** in a subsequent step the loaded substrate (21, 21') is further treated, for example printed.

## Revendications

1. Composant destiné à être monté sur un substrat textile souple (21)
comprenant un support de composants (2) avec une première surface (3) tournée vers le substrat (21, 21'), une deuxième surface (4), de préférence opposée à la première surface (3)
au moins un élément (5, 6) qui est monté sur le support de l'élément (2) et auquel un courant et/ou une tension peut être appliqué,
et au moins deux dépôts de soudure (10) qui sont disposés sur la première surface (3) du support de composants (2), **caractérisé en ce que**
le support de composants (2) comporte au moins deux canaux (9) thermiquement conducteurs qui mènent de la première surface (3) à la deuxième surface (4) et qui sont chacun reliés de manière thermiquement conductrice à au moins un des deux dépôts de soudure (10) au moins,
les canaux (9) étant en particulier des évidements (17) au moins partiellement remplis de soudure (16), et la première surface (3) du support de composants (2) étant au moins partiellement revêtue d'un adhésif (11), en particulier d'un adhésif activable et/ou durcissable thermiquement, en particulier d'un film adhésif (13), les dépôts de soudure (10) étant en particulier revêtus d'un film adhésif (13).

2. Composant selon la revendication 1, **caractérisé en ce que** le composant (1) présente au moins une des propriétés suivantes a)-h),
a) chaque dépôt de soudure (10) présente une surface tournée vers le substrat (21), dont la taille est comprise entre 0,2 mm² et 100 mm², de préférence entre 0,5 mm² et 50 mm², de préférence encore entre 1 mm² et 10 mm²,
b) l'épaisseur de la couche (26) des dépôts de soudure (10) est de 0,01-1mm, de préférence 0,05-0,5mm
c) chaque dépôt de soudure (10) a une distance (27) d'au moins 0,1 mm, de préférence d'au moins 0,2 mm, du bord du support de composants (2),
d) chaque dépôt de soudure (10) est situé à une distance (28) d'au moins 0,3 mm, de préférence d'au moins 0,5 mm, plus préférablement d'au moins 1 mm, de chaque autre dépôt de soudure (10),
e) au moins 50%, de préférence au moins 70%, de préférence au moins 80%, de la première surface (3) sont enduits d'adhésif, en particulier la face (12) du composant (1) tournée vers le substrat (21, 21') est enduite d'adhésif (11),
f) l'épaisseur (29) de l'adhésif (11) est comprise entre 0,01 et 0,5 mm, de préférence entre 0,05 et 0,2 mm,
g) le grammage de l'adhésif (11) est compris entre 10 et 500 g/m² , de préférence entre 20 et 200 g/ m², de préférence entre 50 et 100 g/m²,
h) le support du composant (2) a une épaisseur de matériau (30) comprise entre 10 µm et 2000 µm, de préférence entre 100 µm et 1000 µm.

3. Composant selon la revendication 1 ou 2, **caractérisé en ce que**
les canaux (9) ont chacun un diamètre (D) qui se situe dans une fourchette de 0,1 mm à 2 mm, de préférence de 0,2 mm à 1 mm, et/ou
les canaux (9) ont chacun une distance d'au moins 0,1 mm, de préférence d'au moins 0,5 mm, par rapport au bord du support de composants (2).

4. Composant selon l'une des revendications 1 à 3, **caractérisé en ce que** les canaux (9) sont pourvus d'un couvercle (15), par exemple une couche de cuivre, sur la deuxième surface (4) .

5. Procédé de fabrication d'un composant selon l'une des revendications 1 à 4, comprenant les étapes suivantes
- Equiper un support de composants (2) d'au moins un élément (5, 6) ;
- la fixation d'au moins deux canaux (9) thermiquement conducteurs, qui conduisent chacun d'un premier côté (3) du support de composants (2) à un deuxième côté (4) du support de composants (2), en particulier la réalisation d'évidements continus (17) et le remplissage avec de la soudure (16), les parois intérieures des canaux (9) étant en particulier revêtues de manière conductrice, en particulier avant le remplissage avec de la soudure ;
- appliquer au moins deux dépôts de soudure (10) sur la première face (3) du support de composants (2) ;
- appliquer de l'adhésif (11) sur une face (12) du composant (1) tournée vers le substrat (21).

6. Procédé selon la revendication 5, **caractérisé en ce que** le composant (1, 1') présente au moins une des propriétés suivantes a)-h),
a) chaque dépôt de soudure (10) présente une surface à tourner vers le substrat (21, 21'), dont la taille est comprise entre 0,2 mm² et 100 mm², de préférence entre 0,5 mm² et 50 mm², de préférence encore entre 1 mm² et 10 mm²,
b) l'épaisseur de la couche (26) de chaque dépôt de soudure (10) est de 0,01-1mm, de préférence 0,05-0,5mm
c) chaque dépôt de soudure (10) a une distance (27) d'au moins 0,1 mm, de préférence d'au moins 0,2 mm, du bord du support de composants (2),
d) chaque dépôt de soudure (10) est situé à une distance (28) d'au moins 0,3 mm, de préférence d'au moins 0,5 mm, plus préférablement d'au moins 1 mm, de chaque autre dépôt de soudure (10),
e) au moins 50%, de préférence au moins 70%, de préférence au moins 80%, de la première surface (3) sont enduits d'adhésif (11),
f) l'épaisseur (29) de l'adhésif (11) est comprise entre 0,01 et 0,5 mm, de préférence entre 0,05 et 0,2 mm,
g) le grammage de l'adhésif (11) est compris entre 10 et 500 g/m2 , de préférence entre 20 et 200 g/m2 , de préférence entre 50 et 100 g/m2,
h) le support du composant (2) a une épaisseur de matériau (30) comprise entre 10 µm et 2000 µm, de préférence entre 100 µm et 1000 µm.

7. Procédé selon la revendication 5, **caractérisé en ce que** les canaux (9) ont chacun un diamètre (D) qui se situe dans une plage de 0,1 mm à 2 mm, de préférence de 0,2 mm à 1 mm, et/ou les canaux (9) ont chacun une distance d'au moins 0,1 mm, de préférence d'au moins 0,5 mm, par rapport au bord du support de composants (2).

8. Agencement de composants, comprenant un substrat textile flexible (21, 21') avec des pistes conductrices (22) et au moins un composant (1, 1') selon l'une des revendications 1 à 4, **caractérisé en ce qu'**au moins deux dépôts de soudure (10) du composant (1, 1') sont chacun reliés de manière électriquement conductrice à une piste conductrice (22) et qu'un contact adhésif existe entre le support de composant (2) et le substrat (21, 21').

9. Agencement de composants selon la revendication 8, **caractérisé en ce que** le substrat (21, 21') est renforcé par une couche non conductrice (24), en particulier un renforcement textile (34) et/ou un bord textile (35), au moins dans les zones de contact (23) où les composants (1, 1') sont fixés au substrat (21, 21').

10. Procédé pour appliquer un composant selon l'une des revendications 1 à 4 sur un substrat textile flexible, comprenant les étapes suivantes
- fournir un substrat textile souple (21, 21') avec des pistes conductrices (22) ;
- appliquer le composant (1) sur une zone de contact souhaitée (23) ;
- la réalisation d'une colle et d'une liaison par brasage, en particulier l'application sensiblement simultanée d'une pression, de chaleur et/ou d'un champ électromagnétique sur le composant (1), la liaison par brasage étant réalisée par chauffage ponctuel de canaux (9) depuis le côté (4) du composant (1) opposé au substrat (21).

11. Procédé selon la revendication 10, **caractérisé en ce que** la connexion de soudure est réalisée par chauffage inductif des dépôts de soudure, en particulier à partir du côté (4) du composant (1, 1') opposé au substrat (21, 21').

12. Procédé selon la revendication 10 ou 11, **caractérisé en ce que** la surface de contact (23) et le composant (1) sont maintenus entre un dispositif de pressage, en particulier chauffé.

13. Procédé selon les revendications 10 à 12, **caractérisé en ce que** plusieurs connexions soudées sont produites simultanément.

14. Procédé selon l'une des revendications 10 à 13, **caractérisé en ce que** les composants (1, 1') sont prévus sur une plaque, sur une courroie ou en tant que matériau en vrac et sont en particulier retirés d'un outil, par exemple un outil de prise et de pose, et amenés dans la zone de contact (23).

15. Procédé selon l'une des revendications 10 à 14, **caractérisé en ce que** dans une étape ultérieure, le support (21, 21') est traité davantage, par exemple imprimé.
